# EUROPEAN PATENT APPLICATION

(11) **EP 1 221 771 A1**
(43) Date of publication of application: **10.07.2002**
(21) Application number: 01830005.3
(22) Date of filing: 08.01.2001
(51) Int. Cl.: H03K 17/16

(54) **High configurability output-buffer circuit**

(71) Applicant: STMicroelectronics S.r.l., 20041 Agrate Brianza (Milano) (IT)
(72) Inventor: Sforzin, Marco, 22063 Cantu' (IT); Bedarida, Lorenzo, 20059 Vimercate (IT); Defendi, Marco, 20050 Sulbiate (IT); Nava, Claudio, 20040 Cornate d'Adda (IT)
(74) Representative: Cerbaro, Elena, Dr.

(57) **Abstract**

The output-buffer circuit (1) comprises an end stage (2) made up of a pull-up transistor (3) and a pull-down transistor (4) connected in series between a supply line (5) and a ground line (GND); a first driving stage (8) connected to a control terminal of the pull-up transistor (3) and comprising a plurality of first driving branches (12) which can be selectively activated by a logic control circuit (16) according to the reading and operating modes of a memory device (100) including the output-buffer circuit (1) and to the variability of the electrical parameters of the output-buffer circuit; and a second driving stage (9) connected to a control terminal of the pull-down transistor (4) and comprising a plurality of second driving branches (22) which can also be selectively activated by the control circuit (16) according to the reading and operating modes of a memory device (100) including the output-buffer circuit (1) and to the variability of the electrical parameters of the output-buffer circuit.

## Description

The present invention refers to an output-buffer circuit provided with a high degree of configurability.

As is known, the semiconductor market currently requires memory devices having increasingly higher operating frequencies.

This results in the need to have available output-buffer circuits with increasingly higher switching speeds, and hence of larger size.

However, if the dimensions of the output-buffer circuit are enlarged too much, this may, in certain cases, lead to problems.

For example, the larger the size of the output-buffer circuit, the higher the currents that the circuit absorbs during switching. In these conditions, marked voltage drops may occur in the supply of the memory device. These voltage drops may, for example, generate a considerable reduction in read times of the memory device.

In addition, during the phase of testing of the memory device, it may prove somewhat problematical to preserve high-level performance of the output-buffer circuit because testing is carried out in an environment that is particularly favourable to the occurrence of noise.

Furthermore, in certain reading modes of the memory device it is not necessary to have particularly fast output-buffer circuits. For instance, in the case of random-type reading, where the read times are of the order of 100 ns, the switching speed of the output-buffer circuit is not such a determining factor as it may be in burst-type reading, where, since the device has to read more words in parallel, it has to sustain switching frequencies of even several tens of MHz.

Currently, output-buffer circuits present the drawback of not being configurable according to the different reading modes (random mode/burst mode) and to the different operating modes (user mode/test mode) of the memory device.

In addition, the variability of the electrical parameters depending upon the integration process may lead to the output-buffer circuits behaving in a way different from what was set down in the design phase.

The technical problem that the present invention aims at solving is overcoming the limitations and drawbacks referred to above.

According to the present invention, a high-configurability output-buffer circuit is provided, as defined in Claim 1.

The characteristics and advantages of the output-buffer circuit according to the invention will emerge from the ensuing description of an example of embodiment, which is given to provide a non-limiting illustration, with reference to the attached drawings, in which:
- Figure 1 shows a first embodiment of an output-buffer circuit according to the invention; and
- Figure 2 shows a second embodiment of an output-buffer circuit according to the invention.

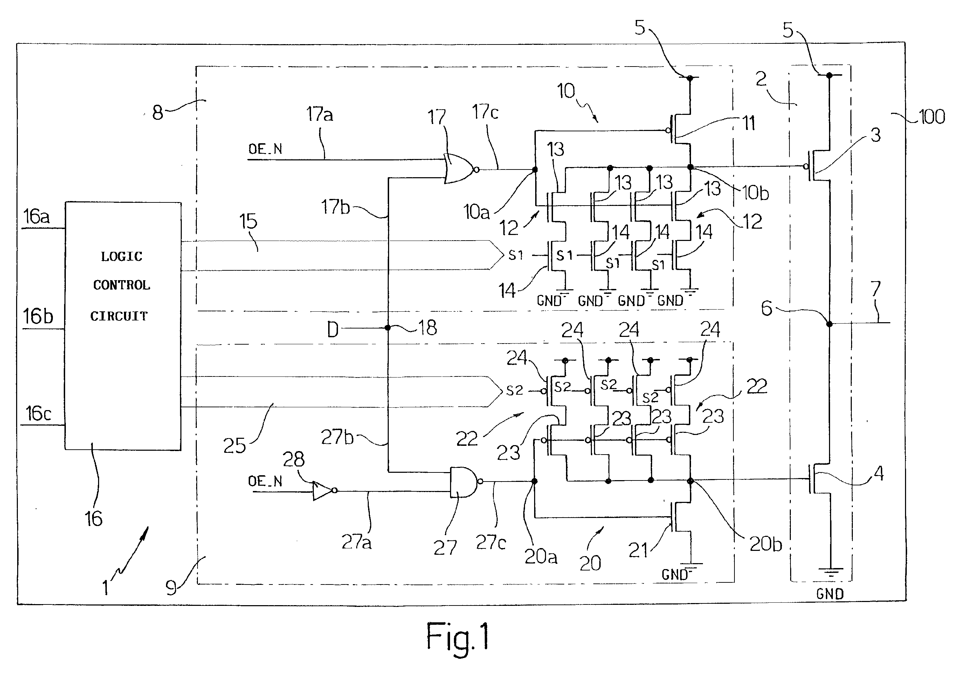

Figure 1 shows an output-buffer circuit 1 comprised in a memory device 100. The output-buffer circuit 1 comprises an end stage 2 made up of a pull-up transistor 3, of the PMOS type, and a pull-down transistor 4, of the NMOS type, connected in series between a supply line 5, set at a supply voltage V_{DD}, and a ground line GND. More precisely, the pull-up transistor 3 has a first terminal connected to the supply line 5 and a second terminal connected to a common node 6 which is in turn connected to a data output 7 of the output-buffer circuit 1. In turn, the pull-down transistor 4 has a first terminal connected to the common node 6 and a second terminal connected to the ground line GND.

The output-buffer circuit 1 also comprises a first driving stage 8 and a second driving stage 9, respectively of the pull-up transistor 3 and of the pull-down transistor 4. The first driving stage 8 and the second driving stage 9 form a driving circuit having a first output connected to a control terminal of the pull-up transistor 3 and a second output connected to a control terminal of the pull-down transistor 4.

In detail, the first driving stage 8 comprises a pull-up inverter 10 having an input node 10a and an output node 10b, the latter being connected to the control terminal of the pull-up transistor 3.

The pull-up inverter 10 comprises a pull-up transistor 11, of the PMOS type, having a first terminal connected to the supply line 5, a second terminal connected to the output node 10b of the pull-up inverter 10, and a control terminal connected to the input node 10a. The pull-up inverter 10 moreover comprises a plurality of pull-down branches 12, only four of which are shown in Figure 1. Each pull-down branch 12 comprises a driving transistor 13 and a selection transistor 14, of the NMOS type, connected in series between the output node 10b of the pull-up inverter 10 and the ground line GND. In detail, the driving transistor 13 has a first terminal connected to the output node 10b, a second terminal connected to the first terminal of the selection transistor 14, and a control terminal connected to the input node 10a. The selection transistor 14 has a second terminal connected to the ground line GND and a control terminal connected to a first signal bus 15 receiving first enabling signals S1 generated by a logic control circuit 16.

The first driving stage 8 further comprises a first logic gate 17, of the NOR type, having a first input terminal 17a receiving an activation/deactivation signal OE_N, a second input terminal 17b connected to a data input 18 of the output-buffer circuit 1, the latter receiving an input data signal D, and an output terminal 17c connected to the input node 10a of the pull-up inverter 10.

Likewise, the second driving stage 9 comprises a pull-down inverter 20 having an input node 20a and an output node 20b, the latter node being connected to the control terminal of the pull-down transistor 4.

The pull-down inverter 20 comprises a pull-down transistor 21, of the NMOS type, having a first terminal connected to the output node 20b of the pull-down inverter 20, a second terminal connected to the ground line GND, and a control terminal connected to the input node 20a. The pull-down inverter 20 moreover comprises a plurality of pull-up branches 22, only four of which are shown in Figure 1. Each pull-up branch 22 comprises a driving transistor 23 and a selection transistor 24, of the PMOS type, connected in series between the supply line 5 and the output node 20b of the pull-down inverter 20. In detail, the driving transistor 23 has a first terminal connected to the supply line 5, a second terminal connected to the first terminal of the selection transistor 24, and a control terminal connected to the input node 20a of the pull-down inverter 20. The selection transistor 14 has a second terminal connected to the output node 20b of the pull-down inverter 20 and a control terminal connected to a second signal bus 25 receiving second enabling signals S2 generated by the logic control circuit 16.

The second driving stage 9 further comprises a second logic gate 27, of the NAND type, having a first input terminal 27a connected to the data input 18, a second input terminal 27b receiving the negated activation/deactivation signal OE_N generated by an inverter 28, and an output terminal 27c connected to the input node 20a of the pull-down inverter 20.

In turn, the logic control circuit 16 has a first input 16a, a second input 16b, and a third input 16c. The first input 16a of the logic control circuit 16 is connected to a command user interface (not shown in Figure 1) supplying information regarding the reading mode (random mode/burst mode) in which the memory device 100 operates. The second input 16b of the logic control circuit 16 is connected to a test-latch (not shown in Figure 1) in which information is stored regarding the operating mode (user mode/test mode) of the memory device 100. The third input 16c of the logic control circuit 16 is connected to flash memory cells referred to as content addressable memory (CAM) cells (not shown in Figure 1), in which, during the testing phase, referred to as electrical wafer sort (EWS) phase, information regarding the integration process used is stored.

The output-buffer circuit 1 of Figure 1 operates as is described in what follows.

Initially, consider the condition in which the activation/deactivation signal OE_N is at a low level, and the input data signal D is at a high level.

In this condition, the first logic gate 17 generates, on the input node 10a of the pull-up inverter 10, a signal at a low level, causing turning-on of the pull-up transistor 11 of the pull-up inverter 10 and turning-off of the driving transistors 13 of the pull-down branches 12. Likewise, the second logic gate 27 generates, on the input node 20a of the pull-down inverter 20, a signal at a low level, causing turning-off of the pull-down transistor 21 of the pull-down inverter 20 and turning-on of the driving transistors 23 of the pull-up branches 22.

There thus occurs turning-off of the pull-up transistor 3 of the end stage 2 and turning-on of the pull-down transistor 4, the turning-on speed of which, according to the invention, depends upon the number of pull-up branches 22 that are active.

In particular, the logic control circuit 16 generates one or more enabling signals S2 according to the reading and operating modes and to the variability of the electrical parameters, as specified by the information received on the inputs 16a, 16b, 16c. Each second enabling signal S2 controls turning-on of the corresponding selection transistor 24, and consequently turning-on of the corresponding pull-up branch 22. To the control terminal of the pull-down transistor 4 of the end stage 2, a current is thus supplied which varies according to the number of pull-up branches 22 selected by the control circuit 16. In particular, this current is higher, the larger the number of pull-up branches 22 selected.

This results in a variation in the turning-on speed of the pull-down transistor 4, and hence in the switching speed of the output-buffer circuit 1, according to the information supplied on the inputs 16a, 16b, 16c of the control circuit 16.

It is moreover possible to size the driving transistors 23 of the pull-up branches 22 in such a way that they will conduct different currents, in order to generate a plurality of different turning-on speeds of the pull-down transistor 4. For example, this can be obtained by sizing the shape ratios of the driving transistors 23 as W/L, 2W/L, 4W/L, 8W/L, or according to any desired law.

When the input data signal D switches to a low level, the first logic gate 17 generates, on the input node 10a of the pull-up inverter 10, a signal at a high logic level, causing turning-off of the pull-up transistor 11 of the pull-up inverter 10 and turning-on of the driving transistors 13 of the pull-down branches 12. Likewise, the second logic gate 27 generates, on the input node 20a of the pull-down inverter 20, a signal at a high logic level, causing turning-on of the pull-down transistor 21 of the pull-down inverter 20 and turning-off of the driving transistors 23 of the pull-up branches 22.

There thus occurs turning-off the pull-down transistor 4 of the end stage 2 and turning-on of the pull-up transistor 3, the turning-on speed of which depends upon the number of pull-down branches 12 active.

In a way similar to what has been described previously, the logic control circuit 16 generates one or more first enabling signals S1 according to the reading and operating modes and to the variability of the electrical parameters. Each first enabling signal S1 controls turning-on of the corresponding selection transistor 14, and consequently turning-on of the corresponding pull-down branch 22. To the control terminal of the pull-up transistor 3 of the end stage 2, a current is thus supplied which varies according to the number of pull-down branches 12 selected by the control circuit 16. In particular, this current is higher, the larger the number of pull-down branches 12 selected.

This results in a variation in the turning-on speed of the pull-up transistor 3, and hence in the switching speed of the output-buffer circuit 1, according to the information supplied on the inputs 16a, 16b, 16c of the control circuit 16.

It is moreover possible to size the driving transistors 13 of the pull-down branches 12 in such a way that they will conduct different currents, in order to generate a plurality of different turning-on speeds of the pull-up transistor 3. For example, this can be obtained by sizing the shape ratios of the driving transistors 13 as W/L, 2W/L, 4W/L, 8W/L, or according to any desired law.

When the activation/deactivation signal OE_N switches to a high level, the first logic gate 17 generates, on the input node 10a of the pull-up inverter 10, a low-level signal, causing turning-on of the pull-up transistor 11 of the pull-up inverter 10 and turning-off of the driving transistors 13 of the pull-down branches 12. In turn, the second logic gate 27 generates, on the input node 20a of the pull-down inverter 20, a high-level signal, causing turning-on of the pull-down transistor 21 of the pull-down inverter 20 and turning-off of the driving transistors 23 of the pull-up branches 22.

In these conditions, the pull-up transistor 3 and the pull-down transistor 4 of the end stage 2 are off. Consequently, the output-buffer circuit 1 is in the high-impedance configuration.

The advantages that may be obtained from the output-buffer circuit according to the present invention emerge clearly from the foregoing description.

Finally, it is clear that modifications and variations may be made to the output-buffer circuit described and illustrated herein, all falling within the scope of the inventive idea, as defined in the attached claims.

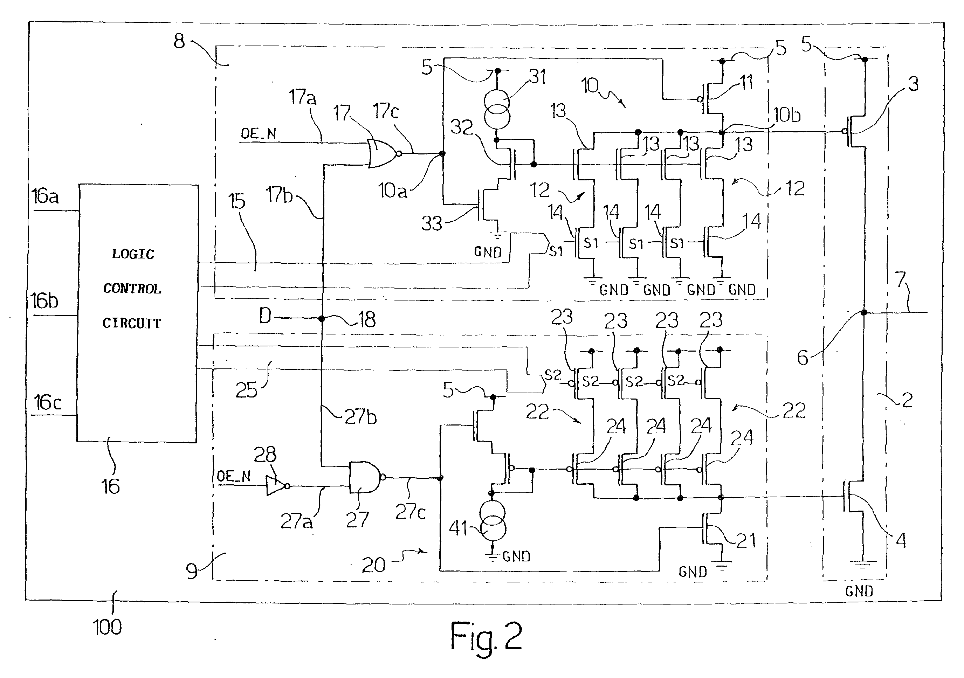

For example, as shown in Figure 2, in which parts that are the same as the parts shown in Figure 1 are designated by the same reference numbers, the pull-down branches 12 of the first driving stage 8 define output branches of a first current-mirror circuit 30 having an input branch 30a connected between the supply line 5 and the ground line GND.

In greater detail, the input branch 30a of the first current-mirror circuit 30 comprises a current generator 31, obtained by means of current mirrors and generating a reference current I_{ref}, which is stable and substantially independent of the supply voltage V_{DD}, and a first transistor 32 and a second transistor 33, both of the NMOS type. Specifically, the current generator 31 has a first terminal connected to the supply line 5 and a second terminal connected to a first terminal of the first transistor 33 of the input branch 30a. The first transistor 33 is diode-connected and has a control terminal connected to the control terminals of the driving transistors 13 of the pull-down branches 12, and a second terminal connected to a first terminal of the second transistor 34 of the input branch 30a. The second transistor 34 also has a second terminal connected to the ground line GND, and a control terminal connected to the input node 10a of the pull-up inverter 10.

Likewise, the pull-up branches 22 of the second driving stage 9 define output branches of a second current-mirror circuit 40 having an input branch 40a connected between the supply line 5 and the ground line GND.

In greater detail, the input branch 40a of the second current-mirror circuit 40 comprises a current generator 41, obtained by means of current mirrors and generating the reference current I_{ref}, and a first transistor 42 and a second transistor 43, both of the PMOS type. Specifically, the current generator 41 has a first terminal connected to the ground line GND and a second terminal connected to a first terminal of the first transistor 42 of the input branch 40a. The first transistor 42 is diode-connected and has a control terminal connected to the control terminals of the driving transistors 23 of the pull-up branches 22, and a second terminal connected to a first terminal of the second transistor 43 of the input branch 40a. The second transistor 43 also has a second terminal connected to the supply line 5, and a control terminal connected to the input node 20a of the pull-down inverter 20.

Operation of this variant of the output-buffer circuit 1 is altogether similar to that of the embodiment described previously.

## Claims

1. An output-buffer circuit (1) comprising:
an end stage (2) made up of a pull-up transistor (3) and a pull-down transistor (4) connected in series between a first reference-potential line (5) and a second reference-potential line (GND);
a driving circuit (8, 9) having a first output connected to a control terminal of said pull-up transistor (3) and a second output connected to a control terminal of said pull-down transistor (4);
**characterized in that** said driving circuit (8, 9) comprises a plurality of driving branches that can be selectively activated.

2. The circuit according to Claim 1, **characterized in that** said driving circuit (8, 9) comprises a first driving stage (8) connected to a control terminal of said pull-up transistor (3) and a second driving stage (9) connected to a control terminal of said pull-down transistor (4);
said first driving stage (8) comprising a plurality of first selectively activatable driving branches (12) connected between said control terminal of said pull-up transistor (3) and said second reference-potential line (GND); and
said second driving stage (9) comprising a plurality of second selectively activatable driving branches (22) connected between said control terminal of said pull-down transistor (4) and said first reference-potential line (5).

3. The circuit according to Claim 2, **characterized in that**:
each first driving branch (12) comprises a driving circuit (13) and a selection transistor (14) connected in series together;
and **in that** each second driving branch (22) comprises a driving transistor (23) and a selection transistor (24) connected in series together.

4. The circuit according to Claim 3, **characterized in that**:
each driving transistor (13) of each first driving branch (12) has a control terminal connected to an input node (10a) of a pull-up inverter (10), said pull-up inverter (10) having an output node (10b) connected to said control terminal of said pull-up transistor (3);
and **in that** each driving transistor (24) of each second driving branch (22) has a control terminal connected to an input node (20a) of a pull-down inverter (20), said pull-down inverter (20) having an output node (20b) connected to said control terminal of said pull-down transistor (4).

5. The circuit according to Claim 4, **characterized in that** it comprises:
a first current-mirror circuit (30) having a first input branch (30a) and a plurality of first output branches, said first input branch (30a) being connected between said control terminal of each driving transistor (13) of each first driving branch (12) and said input node (10a) of said pull-up inverter (10), and said first output branches being each formed by a respective first driving branch (12); and
a second current-mirror circuit (40) having a second input branch (40a) and a plurality of second output branches, said first input branch (40a) being connected between said control terminal of each driving transistor (23) of each second driving branch (22) and said input node (20a) of said pull-down inverter (20), and said second output branches being each formed by a respective second driving branch (22).

6. The circuit according to Claim 5, **characterized in that**:
said first input branch (30a) of said first current-mirror circuit (30) comprises a current generator (31), a first transistor (32), and a second transistor (33) which are connected in series together, said first transistor (32) being diode-connected and having a control terminal connected to said driving transistors (13) of said first driving branches (12);
and **in that** said second input branch (40a) of said second current-mirror circuit (40) comprises a current generator (41), a first transistor (43), and a second transistor (44) connected in series together, said first transistor (42) being diode-connected and having a control terminal connected to said driving transistors (23) of said second driving branches (22).

7. The circuit according to Claim 6, **characterized in that**:
said current generator (31) of said first current-mirror circuit (30) and said current generator (41) of said second current-mirror circuit (40) generate a reference current I_{ref} that is stable and substantially independent of a supply voltage V_{DD} of said output-buffer circuit (1).

8. The circuit according to any of Claims 4 to 7, **characterized in that**:
said pull-up inverter (10) comprises a pull-up transistor (11) connected between said first reference-potential line (5) and said control terminal of said pull-up transistor (3);
and **in that** said pull-down inverter (20) comprises a pull-down transistor (21) connected between said control terminal of said pull-down transistor (4) and said second reference-potential line (GND).

9. The circuit according to any of Claims 3 to 8, **characterized in that**:
each selection transistor (14) of each first driving branch (12) has a control terminal receiving a respective first enabling signal (S1) generated by a control circuit (16);
and **in that** each selection transistor (24) of each driving branch (22) has a control terminal receiving a respective second enabling signal (S2) generated by said control circuit (16).

10. The circuit according to Claim 9, **characterized in that**:
said control circuit (16) is connected to said control terminal of each selection transistor (14) of each driving branch (12) via a first signal bus (15);
and **in that** said control circuit (16) is connected to said control terminal of each selection transistor (24) of each second driving branch (22) by means of a second signal bus (25).

11. The circuit according to Claim 9 or Claim 10, **characterized in that** said control circuit (16) is of a logic type and comprises a first input (16a), a second input (16b), and a third input (16c), said first input (16a) receiving information correlated to a read mode of a memory device (100) comprising said output-buffer circuit (1), said second input (16b) receiving information correlated to an operating mode of said memory device (100), and said third input (16c) receiving information correlated to variations in electrical parameters of said output-buffer circuit (1).

12. The circuit according to any of Claims 8 to 11, **characterized in that**:
said pull-up transistor (3) of said end stage (2) and said pull-up transistor (11) of said pull-up inverter (10) are of the PMOS type, and said driving transistor (13) and selection transistor (14) of said first driving branches (12), and said first and second transistors (32, 33) of said first input branch (30a) of said first current-mirror circuit (30) are of the NMOS type;
and **in that** said pull-down transistor (4) of said end stage (2) and said pull-down transistor (21) of said pull-down inverter (20) are of the NMOS type, and said driving transistor (23) and selection transistor (24) of said second driving branches (22), and said first and second transistors (43, 44) of said second input branch (40a) of said second current-mirror circuit (40) are of the PMOS type.

13. The circuit according to any of Claims 2 to 12, **characterized in that**:
said first driving stage (8) comprises a first logic gate (17), of the NOR type, having a first input terminal receiving an activation/deactivation signal OE_N, a second input terminal connected to a data input (18) of said output-buffer circuit (1), and an output terminal connected to said input node (10a) of said pull-up inverter (10);
and **in that** said second driving stage (9) comprises a second logic gate (27), of the NAND type, having a first input terminal connected to said data input (18) of said output-buffer circuit (1), a second input terminal receiving said negated activation/deactivation signal OE_N, and an output terminal connected to said input node (20a) of said pull-down inverter (20).
